Europäisches Patentamt

European Patent Office

Office européen des brevets

(19)

(11) **EP 0 600 179 B1**

(12) **EUROPÄISCHE PATENTSCHRIFT**

(45) Veröffentlichungstag und Bekanntmachung des Hinweises auf die Patenterteilung:
**08.01.1997 Patentblatt 1997/02**

(51) Int Cl.6: **H02M 7/538**, H02M 7/00, H03K 17/16

(21) Anmeldenummer: **93115684.8**

(22) Anmeldetag: **29.09.1993**

(54) **Leistungshalbleiter-Schaltungsanordnung**

Power semiconductor circuit arrangement

Dispositif de circuit avec semi-conducteurs de puissance

(84) Benannte Vertragsstaaten:
**CH DE FR GB IT LI NL SE**

(30) Priorität: **02.12.1992 DE 4240501**

(43) Veröffentlichungstag der Anmeldung:
**08.06.1994 Patentblatt 1994/23**

(73) Patentinhaber: **EXPORT-CONTOR Aussenhandelsgesellschaft mbH D-90253 Nürnberg (DE)**

(72) Erfinder:
- **Tursky, Werner, Dr. D-91126 Schwabach (DE)**
- **Tovar, Theodor D-90547 Stein (DE)**

(56) Entgegenhaltungen:
**EP-A- 0 166 968**        WO-A-91/09460

**Beschreibung**

Die Erfindung betrifft eine Leistungshalbleiter-Schaltungsanordnung, insbes. Brückenschaltungsanordnung, mit zwei in Reihe geschalteten Leistungshalbleitern, wobei die beiden in Reihe geschalteten Leistungshalbleiter zwischen einem positiven und einem negativen Stromanschluß einer Spannungsquelle vorgesehen sind und zwischen den Leistungshalbleitern ein Wechselstrom-Lastanschluß festgelegt ist. Als Leistungshalbleiter kommen Schaltbauelemente wie Transistoren oder IGBT-Dioden oder Schaltbauelemente mit hierzu antiparallel geschalteter Freilaufdiode in Betracht.

Eine derartige Schaltungsanordnung ist aus der DE-A 41 05 155 der Anmelderin bekannt. Zur Reduktion der Induktivität und folglich zur Reduktion der zur Induktivität proportionalen Überspannung wird bei dieser bekannten Schaltungsanordnung vorgeschlagen, das Schaltbauelement und die Freilaufdiode des entsprechenden Kommutierungszweiges eng benachbart vorzusehen. Der positive und der negative Stromanschluß der Spannungsquelle sind bei dieser bekannten Schaltungsanordnung als einfache Anschlüsse ausgebildet, die zweckmäßigerweise eng benachbart vorgesehen sind.

Eine induktivitätsarme Halbleiteranordnung mit mindestens einem Halbleiterkörper ist aus der EP-A 0 277 546 bekannt. Auch bei dieser bekannten Schaltungsanordnung sind die Anschlußleiter eng benachbart und wenigstens teilweise zueinander parallel angeordnet.

Aus der EP-A 0 088 924 ist ein Halbleiterbauelement in Modulbauweise bekannt, das aus mehreren, untereinander elektrisch verschalteten, räumlich benachbart angeordneten Halbleiterchips und äußeren Anschlußelementen besteht.

Aus der WO 91/09460 ist bekannt, wie Gleichstrom führende Anschlußelemente, im folgenden auch Stromanschlüsse, Anschlußleiter oder Stromleiter genannt, niederinduktiv für jeden Schalter vorgesehen werden können. Die erfinderische Lösung der mehrfachen, mindestens zweifachen, Zuführung der Gleichstromversorgung in Teilstromleitern zu jedem Leistungsschalter wird hier nicht veröffentlicht.

Der Erfindung liegt die Aufgabe zugrunde, eine Leistungshalbleiter-Schaltungsanordnung der eingangs genannten Art zu schaffen, bei welcher eine Zerstörung der Schaltbauelemente infolge von durch schnelle Schaltvorgänge bedingten Spannungsspitzen auf einfache Weise verhindert wird.

Diese Aufgabe wird erfindungsgemäß durch die Merkmale des Anspruchs 1 gelöst, insbesondere dadurch daß der positive und der negative Stromanschluß der Spannungsquelle jeweils von mindestens zwei Teilanschlüssen gebildet sind. Durch diese Teilanschlüsse des positiven und des negativen Stromanschlusses der Spannungsquelle wird der Gesamtstrom entsprechend der Anzahl Teilanschlüsse auf den der Anzahl Teilanschlüsse entsprechenden Bruchteil reduziert. Entsprechend wird der zeitliche Gradient des Gesamtstromes auf den entsprechenden Bruchteil reduziert. Da der induktive Spannungsabfall des Stromanschlusses zu dessen Induktivität und zur besagten Stromänderungsgeschwindigkeit proportional ist, ergibt sich erfindungsgemäß also eine entsprechende Reduktion des induktiven Spannungsabfalls.

Ist die Induktivität jedes Stromanschlusses L, die Anzahl der Teilanschlüsse des Stromanschlusses n und der gesamte den Stromanschluß durchfließende Strom i, so ergibt sich pro Teilanschluß eine Stromstärke von $\frac{i}{n}$. Die Stromänderungsgeschwindigkeit in jedem Teilanschluß beträgt $\frac{1}{n} \cdot \frac{di}{dt}$ und der induktive Spannungsabfall in jedem Teilanschluß $L \cdot \frac{i}{n} \cdot \frac{di}{dt}$. Bei zwei Teilanschlüssen ergibt sich gegenüber einem einfach ausgebildeten Stromanschluß also nurmehr die halbe Überspannung.

Als besonders vorteilhaft hat es sich erwiesen, wenn der positive und der negative Stromanschluß der Spannungsquelle eng benachbart nebeneinander und zueinander parallel mittig zwischen den beiden Leistungshalbleitern vorgesehen sind. Auf diese Weise ergibt sich eine symmetrische Ausbildung der Schaltungsanordnung mit geringer Induktivität und folglich geringem induktivem Spannungsabfall.

Bei einer Schaltungsanordnung der zuletzt genannten Art ist es vorteilhaft, wenn die Teilanschlüsse des positiven und des negativen Stromanschlusses sich jeweils in entgegengesetzte Richtungen erstrecken, wobei die Leistungshalbleiter mindestens annähernd mittig zwischen den Teilanschlüssen vorgesehen sind. Auf diese Weise ergibt sich eine Optimierung der Symmetrie der Schaltungsanordnung mit dem Vorteil einer Minimierung des induktiven Spannungsabfalls und folglich der bei schnellen Schaltvorgängen induzierten Überspannungen in den Stromanschlüssen der Spannungsquelle.

Weitere Einzelheiten, Merkmale und Vorteile ergeben sich aus der nachfolgenden Beschreibung zweier in der Zeichnung dargestellter Schaltungen der erfindungsgemäßen Leistungshalbleiter-Schaltungsanordnung. Es zeigen:

Fig. 1    eine erste Ausführungsform der Leistungshalbleiter-Schaltungsanordnung, und

Fig. 2    eine zweite Ausbildung der Leistungshalbleiter-Schaltungsanordnung.

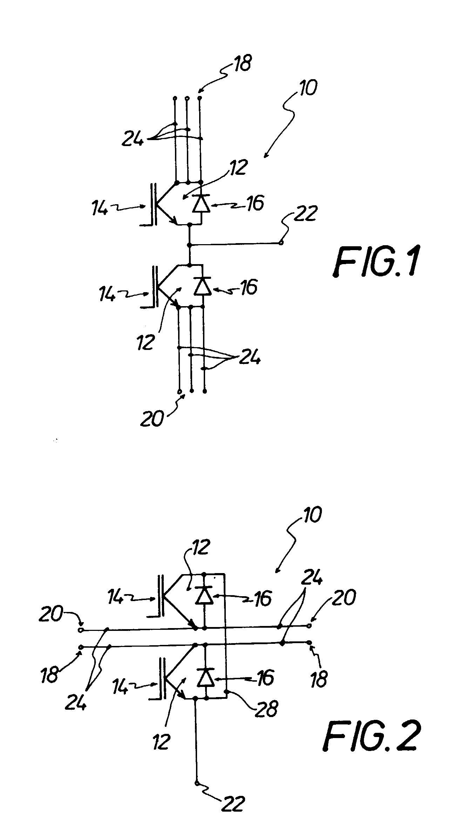

Fig. 1 zeigt eine Leistungshalbleiter-Schaltungsanordnung 10, bei der es sich um eine Brückenschaltungsanordnung handelt, und die zwei in Reihe geschaltete Leistungshalbleiter 12 aufweist. Jede der beiden Leistungshalbleiter 12 weist ein Schaltbauelement 14 und eine zum Schaltbauelement 14 antiparallel geschaltete Freilaufdiode 16 auf. Die beiden Leistungshalbleiter 12 sind zwischen einem positiven Stromanschluß 18 und einem negativen Stromanschluß 20 einer Gleichspannungsquelle vorgesehen. Zwischen den beiden Leistungshalbleitern 12 ist ein Wechselspannungs-Lastanschluß 22 vorgesehen.

Bei dem in Fig. 1 gezeichneten Ausführungsbeispiel der Schaltungsanordnung 10 ist der positive Stromanschluß 18 von drei Teilanschlüssen 24 gebildet. Entsprechend ist der negative Stromanschluß 20 mit drei Teilanschlüssen 24 ausgebildet, wodurch sich pro Teilanschluß 24 eine Reduktion auf ein Drittel des Gesamtstromes ergibt. Diese Reduktion des Stromes pro Teilanschluß 24 bedingt eine entsprechende Reduktion der Stromänderungsgeschwindigkeit in jedem Teilanschluß 24 und folglich eine entsprechende Reduktion des induktiven Spannungsabfalls in jedem Teilanschluß 24. Wie bereits weiter oben erwähnt worden ist, ergibt sich bei drei Teilanschlüssen 24 pro Stromanschluß 18 bzw. 20 eine Reduktion der induktiven Überspannung gegenüber einem einfach ausgebildeten Anschluß 18 bzw. 20 auf ein Drittel. Durch schnelle Schaltvorgänge bedingte Spannungsspitzen führen bei der erfindungsgemäßen Schaltungsanordnung 10 also nicht mehr zu einer Zerstörung insbes. der Schaltbauelemente 14 bzw. der Freilaufdioden 16.

Fig. 2 zeigt eine Ausbildung der Leistungshalbleiter-Schaltungsanordnung 10 mit zwei Leistungshalbleitern 12, von welchen jede ein Schaltbauelement 14 und eine dazu antiparallel geschaltete Freilaufdiode 16 aufweist. Auch bei dieser Ausbildung der Schaltungsanordnung 10 sind die beiden Leistungshalbleiter 12 zwischen dem positiven Stromanschluß 18 und dem negativen Stromanschluß 20 miteinander in Reihe geschaltet. Zwischen den beiden Leistungshalbleitern 12 ist ein Wechselstromlastanschluß 22 festgelegt. Eine symmetrische Ausbildung der Schaltungsanordnung 10 wird bei der Ausführungsform gemäß Fig. 2 dadurch erreicht, daß der positive und der negative Stromanschluß 18, 20 der Spannungsquelle mittig zwischen den beiden Leistungshalbleitern 12 vorgesehen sind. Auch bei dieser Ausbildung der Schaltungsanordnung 10 ist der positive und der negative Stromanschluß 18, 20 der Spannungsquelle jeweils von Teilanschlüssen 24 gebildet, wobei die Teilanschlüsse des positiven Stromanschlusses 18 und die Teilanschlüsse 24 des negativen Stromanschlusses 20 sich jeweils in entgegengesetzte Richtungen erstrecken. Die Leistungshalbleiter 12 sind mindestens annähernd mittig zwischen den sich in entgegengesetzte Richtungen erstreckenden Teilanschlüssen 24 vorgesehen.

Bei der in Fig. 2 gezeichneten Ausbildung der Leistungshalbleiter-Schaltungsanordnung 10 ergibt sich eine Reduktion der induktiven Überspannung in den Stromanschlüssen 18, 20 auf die Hälfte der Überspannung bei einfacher Ausbildung und damit eine erhebliche Entlastung der Schaltbauelemente 14 bzw. der Freilaufdioden 16 der Leistungshalbleiter 12.

## Patentansprüche

1. Leistungshalbleiterschaltungsanordnung, insbesondere Brückenschaltungsanordnung, mit zwei in Reihe geschalteten Leistungshalbleitern (12), wobei die beiden in Reihe geschalteten Leistungshalbleiter (12) mit ihren positiven und negativen Anschlüssen an einen positiven und einen negativen Stromleiter (18, 20) einer Spannungsquelle angeschlossen sind und der gemeinsame Anschluß der Leistungshalbleitern (12) ein Wechselstromlastanschluß (22) bildet,
   **dadurch gekennzeichnet, daß**
   der positive Stromleiter (18) und der negative Stromleiter (20) der Spannungsquelle induktivitätsarm jeweils aus mindestens zwei gleichartigen Teilstromleitern (24) gebildet ist.

2. Schaltungsanordnung nach Anspruch 1, dadurch gekennzeichnet, daß
   die positiven Teilstromleiter (18) mit den zugeordneten negativen Teilstromleiter (20) eng benachbart nebeneinander und zueinander parallel mittig zwischen den beiden Leistungshalbleitern (12) vorgesehen sind.

3. Schaltungsanordnung nach Anspruch 2, dadurch gekennzeichnet, daß
   sich die einzelnen Teilstromleiter der positiven und negativen Stromzuführungen jeweils in entgegengesetzten Richtungen erstrecken, wobei die Leistungshalbleiter (12) mindestens annähernd mittig zwischen den positiven Teilstromleitern (18) und mittig zwischen den negativen Teilstromleitern (20) vorgesehen sind.

## Claims

1. A power semiconductor circuit assembly, especially a bridge circuit assembly, having two power semiconductor elements (12) connected in series, the two power semiconductor elements (12) connected in series being connected to a positive and a negative conductor (18, 20) of a voltage source with their positive and negative terminals, and the common terminal of the power semiconductor elements (12) forming an AC load terminal (22),
   **characterized** by
   the positive conductor (18) and the negative conductor (20) of the voltage source respectively being formed with low inductivity from at least two conductor parts (24) of equal type.

2. A circuit assembly according to claim 1,
   **characterized** in that
   the positive conductor parts (18) and the corresponding negative conductor parts (20) are provided in close vicinity and parallel to one another between the two power semiconductor elements.

3. A cirduit assembly according to claim 2, **characterized** in that the individual conductor parts of the positive and negative current supplies extend in opposite directions, wherein the power semiconductor elements (12) are at least provided substantially in the middle between the positive conductor parts (18) and in the middle between the negative conductor parts (20).

**Revendications**

1. Dispositif de circuit à semi-conducteurs de puissance, en particulier dispositif de circuit en pont, comprenant deux semi-conducteurs de puissance (12) branchés en série, ces deux semi-conducteurs de puissance (12) branchés en série étant raccordés par leurs connexions positives et négatives à un conducteur positif et à un conducteur négatif (18,20) d'une source de tension et la connexion commune des semi-conducteurs de puissance (12) formant une connexion de charge en courant alternatif, caractérisé par le fait que le conducteur positif (18) et le conducteur négatif (20) de la source de tension sont réalisés avec une faible inductance respectivement par au moins deux conducteurs élémentaires identiques (24).

2. Dispositif de circuit selon la revendication 1, caractérisé par le fait que les conducteurs élémentaires positifs (18) sont prévus au voisinage étroit des conducteurs élémentaires négatifs associés (20) les uns à côté des autres et parallèles les uns aux autres centrés entre les deux semi-conducteurs de puissance (12).

3. Dispositif de circuit selon la revendication 2, caractérisé par le fait que les conducteurs élémentaires individuels des alimentations en courant positive et négative s'étendent respectivement dans des sens opposés, les semi-conducteurs de puissance (12) étant prévus au moins sensiblement centrés entre les conducteurs élémentaires positifs (18) et centrés entre les conducteurs élémentaires négatifs (20).

FIG.1

FIG.2